Europäisches Patentamt

European Patent Office

Office européen des brevets

(11) Publication number: **0 266 093 B1**

# EUROPEAN PATENT SPECIFICATION

(45) Date of publication of patent specification: **23.09.92**

(51) Int. Cl.⁵: **H01L 23/48**, H01L 21/603, H01L 29/54

(21) Application number: **87309075.7**

(22) Date of filing: **14.10.87**

The file contains technical information submitted after the application was filed and not included in this specification

(54) **Process of making a high power multi-layer semiconductive switching device with multiple parallel contacts.**

(30) Priority: **27.10.86 US 923674**

(43) Date of publication of application:
**04.05.88 Bulletin 88/18**

(45) Publication of the grant of the patent:
**23.09.92 Bulletin 92/39**

(84) Designated Contracting States:
**CH DE LI SE**

(56) References cited:
EP-A- 0 073 383      EP-A- 0 224 141
FR-A- 2 569 052      US-A- 3 599 060
US-A- 3 633 076      US-A- 4 127 863

PATENT ABSTRACTS OF JAPAN, vol. 10, no. 289 (E-442)[2345], 2nd October 1986; & JP - A - 61 107 753

PATENT ABSTRACTS OF JAPAN, vol. 11, no. 33 (E-476)[2480], 30th January 1987; & JP - A - 61 201 464

IBM TECHNICAL DISCLOSURE BULLETIN, vol. 24, no. 10, March 1982, pages 4954-4955, Ar-monk, New York, US; F. FANG et al."Metallurgical system for silicon metal semiconductor field-effect transistor LSI"

(73) Proprietor: **ELECTRIC POWER RESEARCH IN-STITUTE, INC**
**3412 Hillview Avenue**
**Palo Alto California 94303(US)**

(72) Inventor: **Temple, Victor Albert Keith**
**Main Street**
**Clifton Park New York 12065(US)**

(74) Representative: **Jackson, David Spence et al**
**REDDIE & GROSE 16, Theobalds Road**
**London, WC1X 8PL(GB)**

Rank Xerox (UK) Business Services

EP 0 266 093 B1

## Description

The present invention is directed to the making of a high power multi-layer semiconductive switching device having multiple electrically parallel contacts.

High power semiconductive switching devices must have a relatively large area because of the inherent requirement of carrying high currents. Typically, there are hundreds of individual, for example, gate turn off thyristor devices, which are integrated on a single wafer in a parallel relationship to form such a device.

Because of the large area and the problem of stress under thermal cycling, the making of electrical contact with a single, for example, cathode pole piece with the multiple contacts is a difficult problem. For example, the various contacts, more commonly known in the art as fingers, may have both an excessive forward voltage drop because of the dry type of contact necessary and have differing voltage drops or resistances. If the various fingers do not share current equally, turn off will not occur at the same time and thus unequal currents will be carried. Thus the overall capacity of the device is limited.

Figure 5 illustrates the characteristics of a typical prior art device where the current carried by various multiple contact fingers of a GTO thyristor type device significantly varies from finger to finger. This difference is increased by the addition of a widely variable voltage drop across widely variable dry contact resistances.

In EP-A-0 224 141, which is mentioned here solely in connection with Article 54(3) EPC, a high power multi-layer semiconductive switching device is described in which electrical contact with a plurality of cathode electrodes presented on the upper surface of a substantially flat disc-like silicon power thyristor, having a gate electrode of involute structure, is made by means of a flat disc-like silicon heat sink electrode. Degeneratively doped highly electrically conductive silicon, which has a coefficient of thermal expansion essentially equal to the coefficient of thermal expansion of the substrate of the device, forms the heat sink electrode. The heat sink electrode is permanently attached to the cathode electrode surfaces of the device by hard alloy or eutectic bonding. The use of an aluminium silicon eutectic bond is said to avoid slip or creep between the electrode and the substrate of the device. Layers of aluminium can be applied to the semiconductive surfaces of the heat sink electrode and the device by vacuum deposition or sputtering. To form the eutectic bond, the electrode-device sandwich is heated in a hydrogen atmosphere for half an hour at a temperature in the range of 500°C to 700°C.

Patents Abstracts of Japan, vol. 10, No. 289 (E-442) [2345], of October 2, 1986, (JP-A-61 107 753), describes a multi-layer semiconductive device with an external lead-out electrode plate formed of a silicon substrate of low resistance and held in contact with a plurality of co-planar electrode surfaces of the device. There is no suggestion of a bond to fix the electrode plate to the device electrode surfaces.

It is an object of the present invention to provide an improved high power multi-layer semiconductive switching device having multiple parallel contacts and more specifically such a device where the contact voltage drop for the contacts is substantially reduced and substantially the same for each contact.

According to the present invention there is provided a process of making a high power multi-layer semiconductive switching device having multiple electrically parallel contacts for accommodating large magnitudes of current, comprising the following steps:

providing a switching device of semiconductive material carrying said parallel contacts;

providing a large area unitary contact means substantially consisting of a material matching the thermal expansion characteristics of the semiconductive material of the switching device and carrying at least one electrical contact layer;

and bonding said contact layer to the parallel contacts by thermal compression. This provides a voltage drop of the parallel contacts which is reduced and made substantially similar for each of the contacts.

## Brief Description of the Drawings

Figure 1A is a perspective view in fragmentary form of a cathode contact embodying the present invention.

Figure 1B is a cross-sectional view of an anode portion of a semiconductor switching device embodying the present invention.

Figure 2 is a simplified assembly view of Figures 1A and 1B also illustrating the process for construction of the invention.

Figure 3 is a plan view of Figure 1B showing a much greater area.

Figure 4 is a plan view of Figure 1B substantially taken along the lines 4-4 of Figure 1B.

Figure 5 is a characteristic curve illustrating the prior art.

## Description of Preferred Embodiment

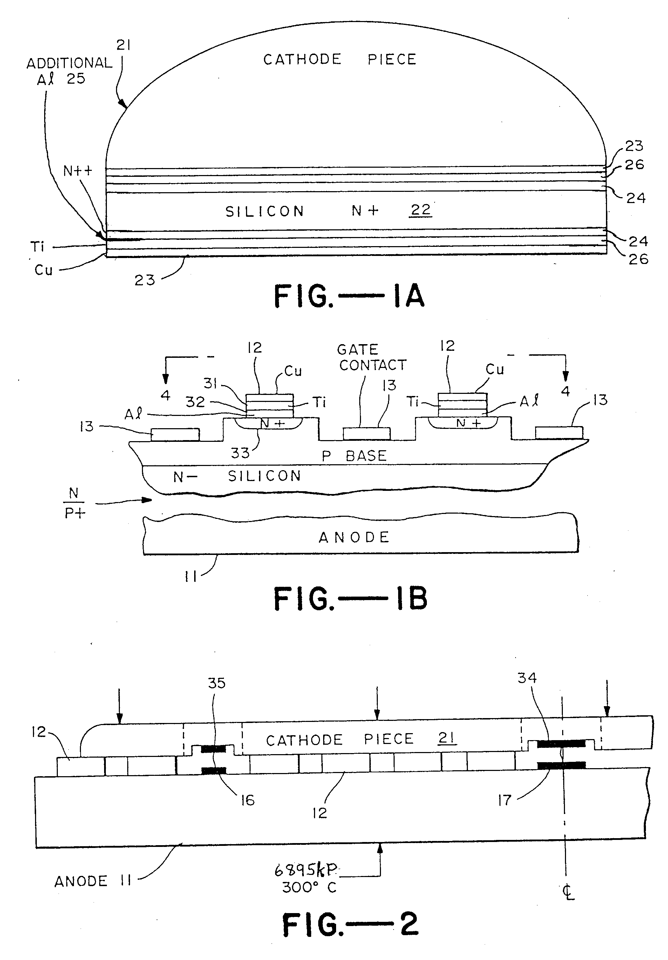

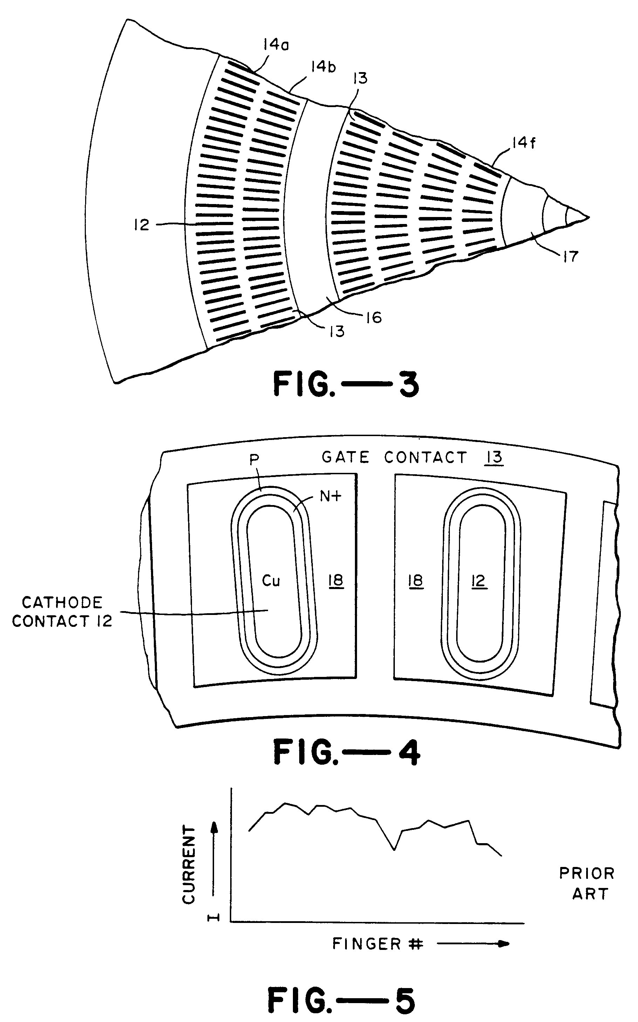

Figure 1B illustrates in simplified form, a gate turn off (GTO) thyristor device which has multiple parallel contacts for accommodating large magnitudes of current. Basically, there is an anode 11, the multiple contacts 12, and gate contacts 13 which are on a P-type base. In general, below each cathode contact 12 is a sequence of doped silicon conductive layers; viz N+, P, N-, N, and P+. Figure 3 is a top view of Figure 1B but including a much greater area which shows several circular areas (specifically 14a through 14f) of the multiple parallel contacts 12 along with the intermediate gate contacts 13 which are connected together by gate contact bands 16 and 17.

Figure 4 shows the foregoing in better detail where each cathode contact 12 is shown as greatly enlarged on top of an N+ mesa surrounded by a P-type mesa, with a valley area being formed as shown at 18 on the P-type base on which the gate contact 13 of deposited metal is placed. All of the gate contacts 13 are then brought out at bands 16 and 17 illustrated in Figure 3.

Since, as illustrated in Figure 3, the entire device is of a relatively large area, thermal loading problems are extensive. Thus, in order to provide a single large unitary contact to the various fingers 12 and to avoid the variation of voltage drop as illustrated in Figure 5 which was created by a prior flat disk of metal which was merely held on the contacts 12 by pressure, there is provided the large area unitary contact 21 of Figure 1A which forms the cathode pole piece of the GTO thyristor structure. This cathode includes as its central core portion 22, semiconductive material of doped silicon, for example N+ with arsenic, which is a material of similar thermal expansion as the silicon material of the active thyristor portion of Figure 1B. Thus any thermal expansion or loading is identically matched between the two portions of Figures 1A and 1B. This allows the cathode portion 21, along with its metallized exterior layers, and specifically its outer layer of copper 23, to be permanently bonded, by thermal compression, to the fingers 12 of Figure 1B. Moreover, by heavily doping with a concentration typically of $5 \times 10^{18}$, conductivity is enhanced to improve forward drop characteristics.

Specifically, the silicon core 22 has diffused in it a highly doped N++ surface layer 24 to prevent a Schottky barrier from forming and to provide improved ohmic contact. This surface layer is of a concentration typically of $10^{20}$ which, of course, is two orders of magnitude higher than N+ core 22. Then an intermediate titanium (Ti) layer 26 is provided between the copper layer 23 and the semiconductive material to prevent migration of the copper to the semiconductive material which might poison it or reduce its lifetime. This Ti layer also (in addition to acting as a barrier) serves to increase adhesion as copper to titanium to silicon has better adhesion than copper to silicon. Titanium also has good adhesion to aluminum. Gold or silver can be substituted for copper as could any material that forms a thermal compression bond at moderate temperatures. Likewise the titanium barrier/adhesion layer could be replaced by chromium, for example. The silicon contact 21 might also include a fairly thick (relative to the barrier/adhesion and thermal compression bond metals) metal layer which is more compliant than silicon so as to more uniformly distribute pressure if the mating surfaces are not perfectly flat; e.g. 5 micrometers of aluminum. This is illustrated in Figure 1A at 25 between the N++ diffusion 24 and Ti layer 26.

The other side of the silicon core 22, has similar layers 23, 24 and 26. The core layer of N+ silicon 22 is arsenic doped to provide a conductivity of approximately .0015 ohm-centimeters. The contact layer 23 is preferably of copper but may be of any other suitable highly conductive metal such as gold or silver. The object is to have it bond to the parallel contacts 12 of Figure 1B at a relatively low temperature and pressure, for example 6895 kilopascals (1,000 psi) at 300°C.

Referring to Figure 1B, under the copper contact finger 12 lies a titanium or chromium adhesion/barrier interface layer 31 which again, as in the case of cathode contact 21, prevents diffusion of the copper into the semiconductive material. This is placed on an aluminium layer 32 which is deposited directly on the N+ island 33. Aluminium is chosen since it interfaces well with the silicon and with the titanium layer 31. Also it provides compression compliance, as discussed above with reference to cathode contact 21 for distributing stress. With respect to the titanium layer, another material such as chromium or chromium silicide could be utilized. Also, the aluminium contact layer to the silicon device could be a refractory metal or a refractory metal silicide in which case the barrier/adhesion layer would be optional.

To permanently bond the cathode contact 21 and its copper contact layer 23 to the multiple parallel contact 12 of Figure 1B, pressure and heat are applied to the opposing sides of the cathode and anode as illustrated in Figure 2. Such pressure might typically be 6895 kilopascals (1,000 psi) at a temperature of 300°C. However, this is not critical. With respect to temperature, it should be lower than 400°C since this is the temperature at which aluminium will start to dissolve some amount of silicon. And then the pressure is limited, of course, by the structural characteristics of the material itself. The various contacts 12 are only schematically illustrated but generally they would be of the format of Figure 3. A key feature of the bonding is that no liquid be formed that would move laterally along the device surface and result in shorted gates, for example. However, if the gate contacts are passivated, the effects of liquid may be minimized.

Gate channels 34 and 35 are placed in cathode piece 21 to allow conductive leads 16 and 17 to the gates to be lead out. Alternatively, cathode piece 21 may be divided as shown by the dashed lines around channels 34 and 35 into a central disk (with a hole in the center) and an outer ring to allow direct electrical connection to the gate contact points. In multi-contact devices where the gates may be at the same level as the cathode finger contacts, (e.g., a power transistor) cathode piece 21 can have its mating surface pre-etched to avoid contact with or bonding to gates.

With the application of the above pressure and heat to form a permanent bond, this provides a current characteristic with reference to Figure 5 which is essentially flat. In other words, there is no variation from contact to contact. Thus, operation of the device is significantly improved since there is no one or small group of contacts which are carrying an excessive amount of current, for example, at turn off.

Typical dimensions of the metal layers, referring to Figure 1B, are an aluminium layer 32 of five micrometers, a titanium layer 31 of 150 nm (1500 angstroms) and a copper layer of one micrometer.

From a semiconductive processing point of view, the various metallic layers are formed by typical evaporation or sputtering techniques. The present invention is applicable in addition to gate turn-off thyristor as illustrated in the preferred embodiment, to other high current devices of relatively large area where a number of multiple parallel contacts are present. In general, this is a significant improvement over previous contact methods which, because sof the inherent mismatch between, for example, the silicon wafer and a metal cathode pole piece, a dry type of contact was required to allow relative lateral movement or "scrubbing" to take place between the contact fingers and the unitary pole piece. In the present invention scrubbing does not take place at the contact fingers, at least, and thus, not only is there achieved a much more uniform and lower forward voltage drop at those critical contact points but also, a much more reliable rugged device due to the elimination of the mechanical scrubbing action.

Thus an improved high power multi-layer semiconductor switching device has been provided.

## Claims

1. A process of making a high power multi-layer semiconductive switching device having multiple electrically parallel contacts (12) for accommodating large magnitudes of current, comprising the following steps:

   providing a switching device (11,13) of semiconductive material carrying said parallel contacts (12);

   providing a large area unitary contact means (21) substantially consisting of a material matching the thermal expansion characteristics of the semiconductive material of the switching device and carrying at least one electrical contact layer (23);

   and bonding said contact layer (23) to the parallel contacts (12) by thermal compression.

2. A process according to claim 1, characterised in that the switching device is a gate turn-off thyristor.

3. A process according to claim 1, characterised in that the contact means (21) is in the shape of a flat disc having its outer surface coated to form the said contact layer (23).

4. A process according to claim 3, characterised in that the contact layer (23) is of copper and a layer (26) of titanium underlies the said copper to prevent migration of the copper to the said material of the unitary contact means (21).

5. A process according to claim 3, characterised in that the said parallel contacts (12) include an outer layer of copper for bonding to the said contact layer (23) of the unitary contact means (21).

6. A process according to claim 3, characterised in that the unitary contact means (21) is formed of a semiconductive material having a highly doped surface diffusion layer (24) for carrying the said contact layer (23).

7. A process according to claim 1, characterised in that the said parallel contacts (12) include a first compression compliant layer (32) consisting of a relatively soft metal and in ohmic contact with the semiconductive material of the switching device, a third or outer layer of metal arranged for thermal compression bonding to the said contact layer (23) of the unitary contact means (21) and a second or intermediate layer (31) adhering to the first and third layers and preventing migration of metal to the said semiconductive material.

8. A process according to claim 7, characterised in that the said first layer (32) is of aluminium, the said second layer (31) is of titanium or chromium, and the said third layer is of copper or gold or silver.

9. A process according to claim 3, characterised in that unitary contact means (21) includes a layer (25) of compression compliant aluminium.

10. A process according to claim 1, characterised in that the unitary contact means (21) consists of a core (22) of semiconductive material having a doping concentration of at least $10^{18}$ atoms/cubic centimeter.

11. A process according to claim 10, characterised in that the said semiconductive material includes a highly doped surface diffusion layer (24) having a concentration at least two orders or magnitude greater than $10^{18}$ atoms/cubic centimeter.

**Patentansprüche**

1. Verfahren zum Herstellen einer mehrschichtigen Halbleiter-Schaltvorrichtung hoher Leistung, mit mehreren elektrisch parallelen Kontakten (12) zur Aufnahme hoher Stromstärken, mit folgenden Schritten:
   - Bereitstellen einer Schaltvorrichtung (11, 13) aus Halbleitermaterial, die die parallelen Kontakte (12) trägt,
   - Bereitstellen einer einheitlichen Kontakteinrichtung (21) mit großer Fläche, die im wesentlichen aus einem Material besteht, das den Wärmedehnungseigenschaften des Halbleitermaterials der Schaltvorrichtung angepaßt ist und wenigstens eine elektrische Kontaktschicht (23) trägt, und
   - Verbinden der Kontaktschicht (23) mit den parallelen Kontakten (12) durch thermische Kompression.

2. Verfahren nach Anspruch 1, dadurch gekennzeichnet, daß die Schaltvorrichtung ein mittels des Gates abschaltbarer Thyristor ist.

3. Verfahren nach Anspruch 1, dadurch gekennzeichnet, daß die Kontakteinrichtung (21) in Form einer flachen Scheibe ausgebildet ist, deren äußere Oberfläche so beschichtet ist, daß die Kontaktschicht (23) gebildet wird.

4. Verfahren nach Anspruch 3, dadurch gekennzeichnet, daß die Kontaktschicht aus Kupfer ausgebildet ist und eine Titanschicht (26) unter dem Kupfer liegt, um eine Wanderung des Kupfers zum Material der einheitlichen Kontakteinrichtung (21) zu verhindern.

5. Verfahren nach Anspruch 3, dadurch gekennzeichnet, daß die parallelen Kontakte (12) eine äußere Kupferschicht zur Verbindung mit der Kontaktschicht (23) der einheitlichen Kontakteinrichtung (21) aufweisen.

6. Verfahren nach Anspruch 3, dadurch gekennzeichnet, daß die einheitliche Kontakteinrichtung (21) aus Halbleitermaterial mit einer hochdotierten Oberflächen-Diffusionsschicht (24) zum Tragen der Kontaktschicht (23) ausgebildet ist.

7. Verfahren nach Anspruch 1, dadurch gekennzeichnet, daß die parallelen Kontakte (12) aufweisen:
   - eine erste nachgiebige Kompressionsschicht (32) aus verhältnismäßig weichem Metall, die in ohmschem Kontakt mit dem Halbleitermaterial der Schaltvorrichtung steht,
   - eine dritte oder äußere Schicht aus Metall, die zur thermischen Kompressionsverbindung mit der Kontaktschicht (23) der einheitlichen Kontakteinrichtung (21) ausgebildet ist, und
   - eine zweite oder Zwischenschicht (31), die an der ersten und der dritten Schicht haftet und eine Wanderung von Metall zum Halbleitermaterial verhindert.

8. Verfahren nach Anspruch 7, dadurch gekennzeichnet, daß die erste Schicht (32) aus Aluminium, die zweite Schicht (31) aus Titan oder Chrom, und die dritte Schicht aus Kupfer, Gold oder Silber besteht.

9. Verfahren nach Anspruch 3, dadurch gekennzeichnet, daß die einheitliche Kontakteinrichtung (21) eine Schicht (25) aus bei Kompression nachgiebigem Aluminium aufweist.

10. Verfahren nach Anspruch 1, dadurch gekennzeichnet, daß die einheitliche Kontakteinrichtung (21) aus einem Kern aus Halbleitermaterial mit einer Dotierkonzentration von wenigstens $10^{18}$ Atomen/cm$^3$ besteht.

11. Verfahren nach Anspruch 10, dadurch gekennzeichnet, daß das Halbleitermaterial eine hochdotierte Oberflächen-Diffusionsschicht (24) mit einer Konzentration aufweist, die wenigstens zwei Größenordnungen größer als $10^{18}$ Atome/cm$^3$ ist.

**Revendications**

1. Procédé pour réaliser un dispositif de commutation semi-conducteur, multi-couches et à haute puissance ayant des contacts électriques multiples parallèles (12) pour recevoir des courants de grande magnitude, comprenant les étapes consistant à :

fournir un dispositif de commutation (11, 13) en un matériau semi-conducteur portant lesdits contacts parallèles (12);

fournir un moyen de contact unitaire (21) à surface large consistant essentiellement en un matériau dont les caractéristiques d'expansion thermique correspondent à celles du matériau semi-conducteur du dispositif de commutation et portant au moins une couche de contact électrique (23);

fixer ladite couche de contact (23) aux contacts parallèles (12) par compression thermique.

2. Procédé selon la revendication 1, caractérisé en ce que le dispositif de commutation est un thyristor interruptible.

3. Procédé selon la revendication 1, caractérisé en ce que le moyen de contact (21) est sous la forme d'un disque plat portant sur sa surface externe un revêtement pour former ladite couche de contact (23).

4. Procédé selon la revendication 3, caractérisé en ce que la couche de contact (23) est en cuivre et qu'une couche (26) en titane se trouve sous ledit cuivre pour empêcher la migration du cuivre dans ledit matériau dudit moyen de contact unitaire (21).

5. Procédé selon la revendication 3, caractérisé en ce que lesdits contacts parallèles (12) comprennent une couche externe de cuivre pour la liaison à ladite couche de contact (23) du moyen de contact unitaire (21).

6. Procédé selon la revendication 3, caractérisé en ce que le moyen de contact unitaire (21) est formé en un matériau semi-conducteur ayant une surface de diffusion hautement dopée (24) pour porter ladite couche de contact (23).

7. Procédé selon la revendication 1, caractérisé en ce que lesdits contacts parallèles (12) comprennent une première couche de compression souple (32) constituée d'un métal relativement mou et en contact ohmique avec le matériau semi-conducteur du dispositif de commutation, une troisième couche métallique ou couche externe prévue pour une fixation par compression thermique à ladite couche de contact (23) du moyen de contact unitaire (21) et une seconde couche ou couche intermédiaire (31) adhérant aux première et troisième couches et empêchant la migration de métal vers ledit matériau semi-conducteur.

8. Procédé selon la revendication 7, caractérisé en ce que ladite première couche (32) est en aluminium, ladite seconde couche (31) est en titane ou en chrome et ladite troisième couche est en cuivre, en or ou en argent.

9. Procédé selon la revendication 3, caractérisé en ce que le moyen de contact unitaire (21) comprend une couche d'aluminium (25) souple en compression.

10. Procédé selon la revendication 1, caractérisé en ce que le moyen unitaire de contact (21) consiste en un noyau (22) de matériau semi-conducteur ayant une concentration de dopage d'au moins $10^{18}$ atomes/centimètre cube.

11. Procédé selon la revendication 10, caractérisé en ce que ledit matériau semi-conducteur comprend en surface une couche de diffusion hautement dopée (24) ayant une concentration supérieure par au moins deux ordres de magnitude à $10^{18}$ atomes/centimètre cube.

ADDITIONAL
Aℓ 25
21

N++

CATHODE PIECE

23
26
24

SILICON    N+    22

Ti
Cu
23

24
26

## FIG.—1A

12
GATE
CONTACT
12

31
32
Cu
Ti
13
Ti
Cu
4

4
Aℓ
Aℓ
13

13
N+
N+

33
P BASE

N− SILICON

N/P+

ANODE

11

## FIG.—1B

35
34

12
CATHODE PIECE 21

16
12
17

ANODE 11

6895kP
300° C

₵

## FIG.—2

14a
14b
13
14f
12
16
13
17

FIG.—3

P
GATE CONTACT 13
N+
Cu
18
18
12
CATHODE CONTACT 12

FIG.—4

CURRENT
I
FINGER #
PRIOR ART

FIG.—5

8